# EUROPEAN PATENT APPLICATION

(11) **EP 3 539 664 A1**
(43) Date of publication of application: **18.09.2019**
(21) Application number: 19386011.1
(22) Date of filing: 13.03.2019
(51) Int. Cl.: B01L 3/00, B01L 7/00

(54) **AN INTEGRATED PCB-BASED MICRODEVICE FOR SENSITIVE NUCLEIC ACID DETECTION, AND METHOD FOR ITS PRODUCTION**

(30) Priority: 13.03.2018 GR 20180100100
(71) Applicant: NATIONAL CENTER FOR SCIENTIFIC RESEARCH "DEMOKRITOS", 15341 Agia Paraskevi Attikis (GR); Chatzandroulis, Stavros, 15341 Agia Paraskevi Attikis (GR); Tserepi, Angeliki, 15341 Agia Paraskevi Attikis (GR)
(72) Inventor: Tserepi, Angeliki, 15341 Agia Paraskevi Attikis (GR); Chatzandroulis, Stavros, 15341 Agia Paraskevi Attikis (GR); Despoina, Moschou, 15341 Agia Paraskevi Attikis (GR); Kaprou, Georgia, 15341 Agia Paraskevi Attikis (GR); Kokkoris, Georgios, 15341 Agia Paraskevi Attikis (GR)

(57) **Abstract**

An integrated microdevice (11) for amplification and detection of nucleic acids comprises a microreactor for nucleic acid amplification in the form of a microfluidic amplification microchamber (1) or in the form of a microchannel, fabricated in one layer of a multilayer PCB structure, a detection microchamber (2) for electrochemical biosensing with a sensing noble-metal plated electrode array (3) allowing the effective immobilization of nucleic acid target probes and electronic quantification of the previously amplified target sequences, fabricated in the same PCB layer as the said microreactor, a microchannel network for delivering the amplified nucleic acid to the said sensing electrode array (3), fabricated in the same PCB layer as the said microreactor, and resistive microheaters (4) for providing the heating zones for nucleic acid amplification and/or denaturation, fabricated in a PCB layer under the said microreactor and/or the said sensing electrode array (3).

## Description

### Field of the Invention

The present invention relates to the field of microfluidic devices for on-chip nucleic acid amplification and on-chip detection of amplified nucleic acid sequences. More specifically, it relates to nucleic acid amplification in a microreactor integrated with microheaters and the detection of amplified nucleic acid sequences on electrochemical sensors, all integrated on a printed-circuit board (PCB) that can be mass produced at PCB manufacturers.

### Background of the invention

Microfluidics is related to the manipulation and treatment of small (in the range of micro/nanoliters) amounts of fluids, employing microfluidic networks with minimum dimension in the range of tens to hundreds of micrometers (µm). Accommodation of conventional laboratory processes in microfluidic platforms (fabricated using well-established microfabrication technology) has drawn great attention, and led to the development of the so-called Lab-on-a-chip (LOC) devices or systems. Typical advantages of microfluidic LOC systems include the possibility to use very small quantities of expensive reagents and scarce samples, to perform high resolution, precise and sensitive detection, and to reduce the analysis time and cost [Whitesides; Nature; 2006; 368-373; 442].

Such systems are capable of mixing reagents, thermal cycling of reagents and sample, performing reactions or other functions, of which the detection of reaction products is of utmost importance. To achieve that, LOC devices or systems comprise microfluidic components, electrical driving circuits and sensor/detector components integrated onto the same substrate. Such a platform integrating a microfluidic device and an electronic circuit is described in US 8715592 B2, where both the microfluidic device and the electronic circuit are fabricated on a semiconductor substrate, mounted on a printed circuit board (PCB) to allow interconnection of the integrated electronic-microfluidic device with external devices through contact structures on PCB.

A problem of such integrated electronic-microfluidic devices according to the prior art is that different substrate materials are used and thus different technologies need to be implemented for the fabrication of such electronic-microfluidic platforms, rendering the integration cumbersome. In addition, an underfill is necessary to seal the microfluidic device onto the PCB. Therefore, integrated microfluidic-electronic devices fabricated seamlessly on a single substrate are desirable. More advantageously, a fabrication technology amenable to mass production is sought, to enhance the potential of such devices for commercialization.

Nucleic acid analysis is an increasingly important tool for a wide variety of biochemical applications, such as molecular diagnostics, and as such it is included as a step in many LOC devices and systems. The uniqueness of nucleic acid sequences allows for the detection of biological agents with a high degree of specificity. However, since the concentration of nucleic acids in biologically derived analytes is low, their concentration must be amplified, to be effectively used as a detection tool. This can be achieved by nucleic acid amplification methods, such as the polymerase chain reaction (PCR) and various isothermal amplification methods (including the helicase dependent amplification (HDA) and the loop-mediated amplification (LAMP)), used for the amplification of DNA and are accommodated in many LOC devices.

The implementation of PCB substrates and the relevant technology for the realization of microdevices for nucleic acid amplification has been described in [Chen S, Rajagopal A and Scherer A 2014 *Thermally controlled chamber with optical access for high-performance pcr.* US 2014/0080133 A1], [Walker C I and Rajagopal A 2012 *System for performing polymerase chain reaction nucleic acid amplification.* US 2012/0264202 A1] and [Rajagopal A, Chen S, Scherer A and Walker C I 2013 *PC Board-based polymerase chain reaction systems, methods and materials.* US 2013/0210080 A1], proposing PCB technology for the fabrication of static chamber PCR devices. However, the detection of amplified DNA is based on optical methods, as is described in the aforementioned patent applications, requiring bulky external instrumentation, usually to convert the collected light into an electrical measurement. Therefore, sensors such as electrochemical ones are more advantageous since they directly provide electrical signal. Furthermore, if these sensors are easily integrable on PCB substrates, they are more desirable. Electrochemical biosensors [Hammond, Jules L., et al., Electrochemical biosensors and nanobiosensors. Essays in Biochemistry, 2016 60(1) p. 69-80] have been widely studied and employed over the past decades, offering quantitative, sensitive and specific detection, while at the same time featuring minimal power consumption and simple electronic instrumentation. They comprise a set of noble metal sensing electrodes, namely working, reference and counter, with a biomarker-specific molecule immobilized on the working electrode surface. A voltage is applied between the working and reference electrodes and the electrical impedance change upon specific binding of the target nucleic acid on the functionalized working electrode is measured between the working and the current electrode. Owing to the fabrication simplicity of this approach and its compatibility with PCB manufacturing, several researchers have recently demonstrated sensitive nucleic acid detection on PCB sensing electrodes, as described in [Sanchez, J.L., et al., Multiplex PCB-based electrochemical detection of cancer biomarkers usingMLPA-barcode approach. Biosens Bioelectron, 2016. 82: p. 224-32], [GANG, C., et al., Circuit board for gene detection*.* CN103257163 (A), 2013], [O'daly, J.P., et al., A printed circuit board, biosensor and method of using same. 2001, WO2001011080 A1], and *[Preparation method for biochip of electrochemical gene sensor.* 2014, CN103627788 A].

The integration of microfluidic devices capable of performing DNA amplification by means of PCR with electrochemical sensors for detecting amplified nucleic acids has been described in [Lee J H, Lee J C, Yoon D and Lim G 2006 Method for detecting PCR product using electrical signal*.* US7,13 5,294 B2], and [Han J I and Oh K 2005 Micro PCR device, method for amplifying nucleic acids using the micro PCR device, and method for measuring concentration of PCR products using the micro PCR device*.* US 2005/0191686 A1], however they are implemented on substrates and processes not amenable to batch production (such as PCB manufacturing).

It is therefore an object of the present invention to provide an integrated microdevice for multiple nucleic acid target amplification and detection, combining nucleic acid amplification and electrochemical detection modules fabricated seamlessly on multilayer PCB with a fully compatible PCB manufacturing process. It is the first time that a complete fabrication process for a fully functional, PCB-based nucleic acid detection platform is disclosed, incorporating also PCB-compatible manufacturing strategies for the critical steps of sensing electrode surface cleaning and immobilization of nucleic acid target probes in a fluidically sealed PCB microdevice.

### Summary of the invention

This object as far as an integrated microdevice is concerned is solved by the features of patent claim 1. Independent claim 6 is directed to a process for the fabrication of an integrated microdevice. Further embodiments and advantages according to the invention are obtained from the subclaims.

Accordingly, an integrated microdevice for amplification and detection of nucleic acids is proposed, comprising a microreactor for nucleic acid amplification in the form of a microfluidic microchamber or in the form of a microchannel, fabricated in one layer of a multilayer PCB structure, a detection microchamber for electrochemical biosensing with a sensing noble-metal plated electrode array allowing the effective immobilization of nucleic acid target probes and electronic quantification of the previously amplified target sequences, fabricated in the same PCB layer as the said microreactor, a microchannel network for delivering the amplified nucleic acid to the said sensing electrode array, fabricated in the same PCB layer as the said microreactor, and resistive microheaters for providing heating zones for nucleic acid amplification and/or denaturation, fabricated in a PCB layer under the said microreactor and/or the said sensing electrode array. According to the invention, the process for the fabrication of an integrated microdevice for amplification and detection of nucleic acids on a multilayer PCB structure as presented within the framework of the invention comprises the following steps:
- formation of resistive microheaters and contact pads on the bottom copper layer of a PCB substrate by means of lithography and wet chemical etching or alternatively by computer numerical control (CNC) machining;
- formation of the sensing electrode array and contact pads on the top copper layer of the said multilayer PCB substrate by means of lithography and wet chemical etching or alternatively by computer numerical control (CNC) machining;

- formation of the microreactor in the form of a microfluidic amplification microchamber or in the form of a microchannel and microchannel network on a dry photoresist layer laminated on top of the sensing electrode array by means of photolithography and sealing them by means of a sealing film, preferably by means of a PCB-compatible adhesive layer;
- noble-metal electroplating of the said sensing electrode array with a process allowing reliable sensing functionality;
- surface treatment of the said noble-metal electroplated sensing electrodes of the said sensing electrode array; and
- functionalization of the said sensing electrodes of the said sensing electrode array in the sealed device.

### Brief description of the drawings

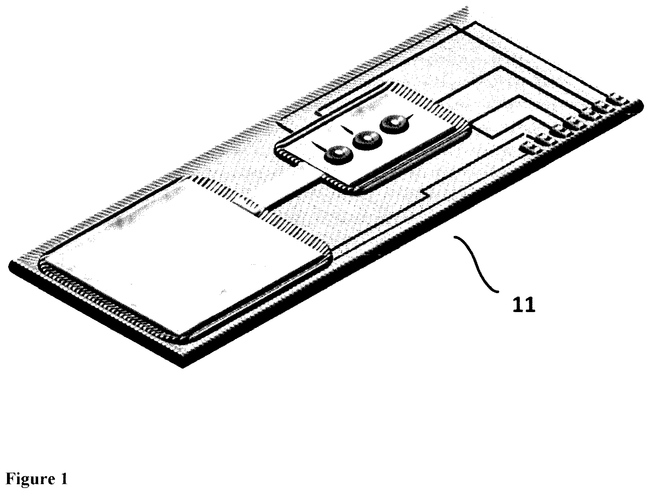

The invention is explained in detail hereinafter with reference to the appended figures as an example. **Figure 1** shows a top-view of an integrated microdevice for amplification and detection of nucleic acids according to an embodiment of the invention, whereby **Figure 2** is a cross-section thereof. Moreover, **Figure 3** illustrates the manufacturing process of an integrated microdevice for amplification and detection of nucleic acids according to an embodiment of the invention.

### Detailed description of the invention

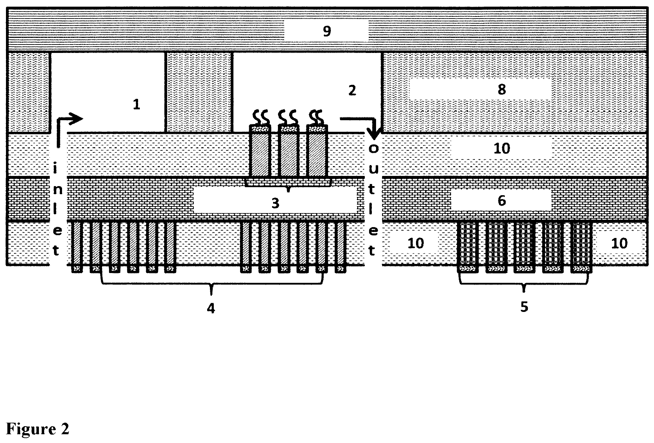

Referring to Figure 2, the integrated microdevice (11) for amplification and detection of nucleic acids on a multilayer PCB structure comprises a multilayer PCB structure, comprising a microreactor in the form of a microfluidic microchamber (1) for nucleic acid amplification, fabricated in one layer of a multilayer PCB structure, a detection microchamber (2) for electrochemical biosensing with a sensing noble-metal plated electrode array (3), fabricated in the same PCB layer as the said microreactor, allowing the effective immobilization of nucleic acid target probes and electronic quantification of the previously amplified target sequences, a microchannel network for delivering the amplified nucleic acid to the said sensing electrode array (3), fabricated in the same PCB layer as the said microreactor, resistive microheaters (4) for providing heating zones for nucleic acid amplification and/or denaturation, fabricated in a PCB layer under the said microreactor and/or the said sensing electrode array. As can be taken from Figure 2, the integrated microdevice for amplification and detection of nucleic acids on a multilayer PCB structure comprises contact pads (5) for electrical interfacing to external instrumentation.

In more detail, to allow performance of nucleic acid amplification using multi-temperature or single-temperature (isothermal) protocols, the device comprises a microfluidic microchamber (1) for nucleic acid amplification fabricated on one side of a PCB substrate, whereby the electrically driven resistive microheaters (4) produce enough heat to raise the temperature of a fluid within the amplification microchamber (1). According to the invention, the microfluidic amplification microchamber (1) may be thermocycled by means of the electrically driven resistive microheaters (4) between two or three temperatures, such as in PCR-based amplification protocols for DNA amplification, or kept at a single temperature, such as in isothermal DNA amplification protocols.

Subsequently, the amplified nucleic acid product is delivered via a connecting microfluidic channel on the array of sensing electrodes (3) which contains several sets of sensing electrodes in the detection microchamber (2). According to the invention, the array of sensing electrodes (3) comprises several sets of sensing electrodes, each set of sensing electrodes of the array of sensing electrodes (3) is functionalized to identify a specific nucleic acid sequence, thus the array (3) is able to detect multiple sequences at the same time.

Each set of sensing electrodes comprises a working electrode, where the nucleic-acid specific probe is immobilized, a reference electrode and an auxiliary (counter) electrode, if required. Functionalization of the working electrodes can take place either in open microchannels by spotting a biomolecular solution on the electrodes or in the sealed multilayer PCB structure.

In the latter case, in order to assure that no cross-contamination between adjacent working and auxiliary electrodes is taking place when functionalizing the sensors in the sealed multilayer structure, auxiliary immobilization inlets and outlets are exploited between the working electrodes functionalized for each different target nucleic acid.

A voltage is applied between the working and reference electrodes and the electrical impedance change upon specific binding of the target nucleic acid on the functionalized working electrode is measured between the working and the current electrode.

An integrated heating element can also be implemented under the array of sensing electrodes (3) array as shown in Figure 2, in order to assure the target double-stranded nucleic acid denaturation in single strands. The sensing electrodes bear a noble metal plating compatible with commercial PCB processing (e.g. gold, silver, etc.) and are chemically and mechanically pre-processed to optimize their biomolecule binding capacity. The sensors are connected electrically to an external instrumentation applying the respective electrical bias and measuring the respective detection signal between each set of electrodes.

The microchannel network for delivering the amplified nucleic acid to the sensing electrode array (3) may comprise chambers for nucleic acid extraction from cells, e.g. through thermal lysis and amplification, and microchannels for transporting the amplified nucleic acids and detecting them on the array of sensing electrodes (3).

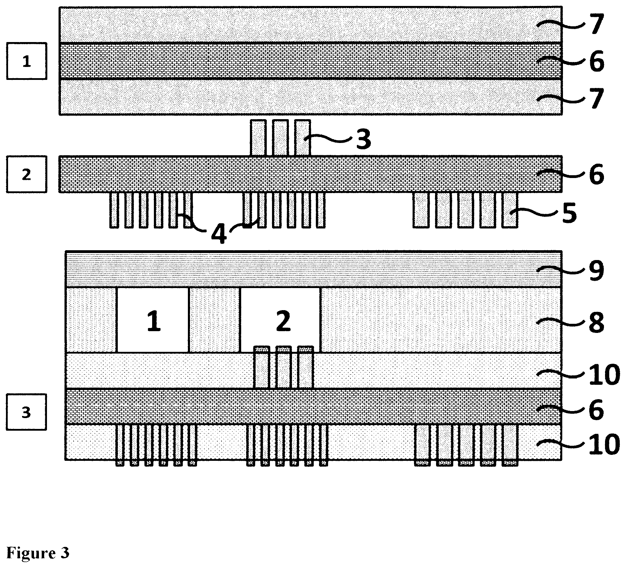

According to the invention, the fabrication of the microdevice (11) for amplification and detection of nucleic acids on a multilayer PCB structure entails processing of multilayer PCB substrates in a manner fully compatible with commercial PCB manufacturing. The fabrication method is described with reference to Figures 2 and 3.

The fabrication process starts with a backing/core substrate (6) commonly used in the PCB industry (such as FR4, Rogers, Kapton copper-clad laminates, etc.) bearing at least one copper conductive layer (7) on both sides (step 1 in Figure 3).

The bottom copper side of the substrate is patterned preferably by means of lithography and wet chemical etching, or alternatively by computer numerical control (CNC) machining, to form resistive microheaters (4) and contact pads (5) for electrical interfacing to an external instrumentation. The top copper side is patterned preferably by means of lithography and copper etching or alternatively by computer numerical control (CNC) machining to form an array of sensing electrodes (3) and optionally contact pads, for implementing multiple electrochemical nucleic acid target detection (step 2 in Figure 3). In some embodiments, vias are formed to interconnect copper tracks, for example in the case that microheaters (4) extend over more than one copper layer or contact pads need to be formed on one PCB side. The said sensing electrode array (3) is electroplated with a hard noble-metal surface finish in order to provide the appropriate noble metal surface required for electrochemical biosensing by means of the array of sensing electrodes (3).

The microchannel network, the microchamber (1) for nucleic acid amplification and the detection microchamber (2) are formed preferably by means of photolithography on a dry film photoresist layer (8) and are sealed by means of a sealing film (9) to provide an enclosed microfluidic network (step 3 in Figure 3). The dry film photoresist layer (8) may be laminated on the top side of the PCB stack, which is advantageously covered with solder mask (10) to provide a leveled platform for formation of the microchannel network. The backing/core substrate (6) is covered on both sides with solder mask (10).

The electroplated sensing electrode surface is subsequently chemically pre-treated to remove process-related surface impurities, hindering the reliable biosensor performance. The surface pre-treatment can be implemented by wet chemistry, preferably by immersion in base Piranha solution, a 5:1:1 water:H₂O₂:NH₄OH or via O₂ plasma processing. For sealing the microchannel network, a commercially available adhesive bonding layer may be used, according to the patent-pending Greek application No 20170100305. The sealed structure may be subjected to a final O₂ plasma treatment prior to probe immobilization on the sensing electrodes, so as to purify the noble-metal surface and sterilize the PCB microdevice for subsequent use.

In another embodiment, the dry film photoresist layer (8) is laminated on a second PCB substrate which is aligned and glued on the top side of the PCB stack bearing the microheaters and contact pads to form an enclosed microfluidic network. In this case, chemical pretreatment of the electroplated sensing electrode surface is implemented only via O₂ plasma processing, combined with the final sterilization step.

The fabricated multilayer PCB structure is designed to fit in slot-type electronic connectors, enabling the control and read-out of the board components via external electronic instrumentation.

## Claims

1. An integrated microdevice (11) for amplification and detection of nucleic acids comprising:
- a microreactor for nucleic acid amplification in the form of a microfluidic amplification microchamber (1) or in the form of a microchannel, fabricated in one layer of a multilayer PCB structure;
- a detection microchamber (2) for electrochemical biosensing with a sensing noble-metal plated electrode array (3) allowing the effective immobilization of nucleic acid target probes and electronic quantification of the previously amplified target sequences, fabricated in the same PCB layer as the said microreactor;
- a microchannel network for delivering the amplified nucleic acid to the said sensing electrode array (3), fabricated in the same PCB layer as the said microreactor; and
- resistive microheaters (4) for providing the heating zones for nucleic acid amplification and/or denaturation, fabricated in a PCB layer under the said microreactor and/or the said sensing electrode array (3).

2. An integrated microdevice (11) for amplification and detection of nucleic acids according to claim 1, wherein it comprises contact pads (5) for electrical interfacing to external instrumentation.

3. An integrated microdevice (11) for amplification and detection of nucleic acids according to claim 1 or 2, wherein the microreactor is thermocycled by means of the electrically driven resistive microheaters (4) between two or three temperatures, such as in PCR-based amplification protocols for DNA amplification, or kept at a single temperature, such as in isothermal DNA amplification protocols.

4. An integrated microdevice (11) for amplification and detection of nucleic acids according to claim 1, 2 or 3, wherein the array of sensing electrodes (3) comprises several sets of sensing electrodes, each set of sensing electrodes of the array of sensing electrodes (3) being functionalized to identify a specific nucleic acid sequence.

5. An integrated microdevice (11) for amplification and detection of nucleic acids according to claim 4, wherein each set of sensing electrodes comprises a working electrode, where the nucleic-acid specific probe is immobilized, a reference electrode and an auxiliary (counter) electrode, whereby functionalization of the working electrodes can take place either in open microchannels by spotting a biomolecular solution on the electrodes or in the sealed multilayer PCB structure.

6. A process for the fabrication of an integrated microdevice (11) according to claims 1-5 for amplification and detection of nucleic acids via commercial PCB-compatible processes, comprising the following steps:
- formation of the resistive microheaters (4) and contact pads (5) on the bottom copper layer of a PCB substrate (6) bearing at least one copper conductive layer (7) on both sides by means of lithography and wet chemical etching or alternatively by computer numerical control (CNC) machining;
- formation of the sensing electrode array (3) and optionally contact pads on the top copper layer of the said PCB substrate (6) by means of lithography and wet chemical etching or alternatively by computer numerical control (CNC) machining;
- formation of the microreactor and the microchannel network on a dry photoresist layer (8) laminated on top of the sensing electrode array (3) by means of photolithography and sealing them by means of a sealing film (9);
- noble-metal electroplating of the said sensing electrode array (3);
- covering the substrate (6) on both sides with solder mask (10);
- surface treatment of the noble-metal electroplated sensing electrodes of the sensing electrode array (3); and
- functionalization of the sensing electrodes of the sensing electrode array (3) in the sealed device (11).

7. A process for the fabrication of an integrated microdevice (11) according to claim 6, wherein the surface treatment of the noble-metal electroplated sensing electrodes is implemented by wet chemistry, preferably by immersion in base Piranha solution, a 5:1:1 water:H₂O₂:NH₄OH or via O₂ plasma processing.

8. A process for the fabrication of an integrated microdevice (11) according to claim 6, wherein the sealing of the microreactor and the microchannel network is performed by means of a commercially available adhesive bonding layer.

9. A process for the fabrication of an integrated microdevice (11) according to claim 8, wherein the sealed structure is subjected to a final O₂ plasma treatment prior to probe immobilization on the sensing electrodes, so as to purify the noble-metal surface and sterilize the microdevice (11) for subsequent use.
